# EUROPÄISCHE PATENTSCHRIFT

(11) **EP 1 191 377 B1**
(45) Veröffentlichungstag und Bekanntmachung des Hinweises auf die Patenterteilung: **19.12.2007**
(21) Anmeldenummer: 01119486.7
(22) Anmeldetag: 14.08.2001
(51) Int. Cl.: G02B 7/185

(54) **System zur gezielten Deformation von optischen Elementen**
System for the controlled deformation of optical elements
Système pour la déformation controllée des élements optiques

(30) Priorität: 20.09.2000 DE 10046379
(43) Veröffentlichungstag der Anmeldung: 27.03.2002
(73) Patentinhaber: Carl Zeiss SMT AG, 73447 Oberkochen (DE)
(72) Erfinder: Melzer, Frank, 73469 Utzmemmingen (DE); Sorg, Franz, 73433 Aalen (DE); Muehlbeyer, Michael, 73430 Aalen (DE); Xalter, Stefan, 73447 Oberkochen (DE); Gellrich, Bernhard, 73434 Aalen (DE); Ittner, Thomas, 73431 Aalen (DE)
(74) Vertreter: Lorenz, Werner

(56) Entgegenhaltungen:
- EP-A- 0 744 641
- EP-A- 0 779 530
- WO-A-99/67683
- US-A- 4 959 531
- US-A- 5 986 795
- ELLIS, EDRIC MARK: "Low-cost Bimorph Mirrors in Adaptive Optics" [Online] April 1999 (1999-04), , LONDON , XP002289892 Gefunden im Internet: URL:http://www.op.ph.ic.ac.uk/theses/EMETh es.pdf> [gefunden am 2004-07-22] * Kapitel 3.2, 5.3.2, 5.5, 5.7 * * Abbildungen 1.1,2.9,3.1,4.6 *
- SATO T ; ISHIDA H ; IKEDA O: "Adaptive PVDF piezoelectric deformable mirror system" APPLIED OPTICS, Bd. 19, Nr. 9, 1. Mai 1980 (1980-05-01), Seiten 1430-1434, XP002289889
- SATO T ; ISHIKAWA H ; IKEDA O: "Multilayered deformable mirror using PVDF films" APPLIED OPTICS, Bd. 21, Nr. 20, 15. Oktober 1982 (1982-10-15), Seiten 3664-3668, XP002289890
- SATO T ; UEDA Y ; IKEDA O: "Transmission-type PVDF 2-D optical phase modulator" APPLIED OPTICS, Bd. 20, Nr. 2, 15. Januar 1981 (1981-01-15), Seiten 343-350, XP002289891
- RO J ; BAZ A: "Vibration control of plates using self-sensing active constrained layer damping" PROCEEDINGS OF THE SPIE - THE INTERNATIONAL SOCIETY FOR OPTICAL ENGINEERING, SMART STRUCTURES AND MATERIALS 1999, PASSIVE DAMPING AND ISOLATION, NEWPORT BEACH, CA, USA, 1-2 MARCH 1999, Bd. 3672, 1999, Seiten 200-209, XP002289996

## Beschreibung

Die Erfindung betrifft ein System zur Deformation von optischen Elementen in einer Abbildungseinrichtung, insbesondere in einer Projektionsbelichtungsanlage mit einem Projektionsobjektiv für die Halbleiter-Lithographie zur Beseitigung von Abbildungsfehlern oder zur aktiven Verstellung.

Auf vielen optischen Gebieten, insbesondere in der Halbleiter-Lithographie, werden sehr hohe Abbildungsgenauigkeiten gefordert. Bildfehler sollen immer mehr minimiert werden. Eine der Hauptursachen von Bildfehlern sind dabei Deformationen der optischen Elemente. Derartige Deformationen können über Fassungen eingebracht werden bzw. durch Fassungen entstehen. Auch Gewichtskräfte auf optische Elemente können zu Deformationen und damit zu Abbildungsfehlern führen.

Zum allgemeinen Stand der Technik wird auf die WO 97/34171 hingewiesen.

Der Artikel "Low-cost Bimorph Mirrors in Adaptive Optics" von Edric Mark Ellis, Imperial College, University of London, April 1999 befasst sich mit den Deformationen eines bimorphen adaptiven Spiegels. Dabei ist unter anderem vorgeschlagen, auf der von der Spiegeloberfläche abgewandten Rückseite eines Spiegels eine piezoelektrische Schicht anzuordnen, durch die die Spiegeloberfläche in ihrer Gesamtheit bei einer Aktivierung des piezoelektrischen Effektes die Spiegelstruktur verformt wird, um ein schnelles Fokussiersystem durch Änderung der Spiegelform zu erreichen.

In dem Artikel "Adaptive PVDF piezoelectric deformable mirror system", Applied Optics, Vol. 19, No. 9, 1. Mai 1980 von Takuso Sato u.a. ist ein deformierbares Spiegelsystem mit einer Deformation einer PVDF-Struktur beschrieben.

Der Artikel "Transmission-type PVDF 2-D optical phase modulation", Applied Optics, Vol. 20, No. 2, 15 Januar 1981 von Takuso Sato u.a. betrifft ein Phasenmodulationssytem.

Zur präzisen Justierung einer Abbildungsvorrichtung, z.B. eines Projektionsobjektives, einzelne optische Elemente aktiv zu verstellen, um z.B. Fehler im Objektiv auf diese Weise zu kompensieren oder auch Montageungenauigkeiten auszugleichen.

Der vorliegenden Erfindung liegt die Aufgabe zugrunde, ein System der eingangs erwähnten Art zu schaffen, mit welchem auf sehr umfassende Weise gezielte Deformationen an einem optischen Element vorgenommen werden können und/oder auch sehr gezielte und feinstfühlige aktive Verstellungen möglich sind.

Erfindungsgemäß wird diese Aufgabe durch die in Anspruch 1 genannten Merkmale gelöst.

Erfindungsgemäß werden nunmehr piezoelektrische Elemente als Aktuatoren in Form von dünnen Platten, Folien oder Schichten verwendet, die man gezielt auf zu deformierende Flächen anbringt oder in diese integriert. In Zusammenarbeit mit Sensoren wird eine Art adaptronischer Regelkreis geschaffen, womit sehr präzise und sehr genau auf erkannte Deformationen eingegangen und diese entsprechend behandelt werden können. Ebenso ist es auf diese Weise möglich, sehr präzise durch über die Aktivierung der piezoelektrischen Elemente aufgebrachten Kräfte und/oder Momente gezielte Deformationen in das optische Element einzubringen.

Zwar ist die Verwendung von piezoelektrischen Elementen grundsätzlich bereits in der Optik bekannt, wozu z.B. auf die WO 97/09642, die US-PS 4,202,605 und die US-PS 5,986,795 verwiesen wird, wobei jeweils piezoelektrische Elemente in Form von "Piezo Stacks" Deformationskräfte auf optische Elemente ausüben, aber im vorliegenden Fall werden gezielt dünne Platten, Folien oder Schichten verwendet, die z.B. in Form von Beschichtungen oder über Klebeverfahren direkt auf die zu deformierenden Flächen aufgebracht werden und dort zielgerichtet angeordnet und ausgerichtet werden. Gleichzeitig ist dabei eine Rückkoppelung über Sensoren und einem adaptronischen Regelkreis derart vorgesehen, daß auf diese Weise sehr präzise und innerhalb kleinster Toleranzen agiert werden kann.

Als Sensoren werden piezoelektrische Elemente verwendet, in Form von dünnen Platten, Folien oder Schichten, wie z.B. Keramikfolien, die als Sensoren wirken und mit den piezoelektrischen Elementen als Aktuatoren zusammenwirken. Hierzu können die Sensoren und Aktuatoren abwechselnd angeordnet werden.

Bei dieser erfindungsgemäßen Lösung werden piezoelektrische Elemente in zweifacher Hinsicht benutzt, nämlich zum einen führen auftretende Deformationen oder Schwingungen zu Längenänderungen der piezoelektrischen Elemente, die sich damit nach Art eines Dehnmeßstreifens entsprechend verbiegen. Diese Änderungen der piezoelektrischen Elemente erzeugen Spannungen, welche entsprechend detektiert und ausgewertet werden. In dieser Art wirken die piezoelektrischen Elemente als Sensoren.

Bei einem Einsatz als Aktuatoren wird die umgekehrte Wirkung verwendet, in diesem Fall werden über Steuerleitungen den piezoelektrischen Elementen Spannungen auferlegt, welche zu entsprechenden Längenänderungen bzw. Verbiegungen der piezoelektrischen Elemente führen. Diese Änderungen initiieren damit Schwingungen bzw. Deformationen in die bzw. der angrenzenden Struktur. Über den adaptronischen Regelkreis werden dabei die Deformationen so gesteuert bzw. geregelt, daß man äußerst präzise die gewünschten Wirkungen erzielt, wie z.B. der Entgegenwirkung von entdeckten Deformationen zur Einhaltung einer Abbildungsgenauigkeit, der Kompensation von Gewichtskräften, die zu Deformationen führen oder auch zur aktiven Verstellung, um entdeckten Abbildungsfehlern entgegenzuwirken bzw. diese auszugleichen.

In einer vorteilhaften Ausgestaltung der Erfindung kann auch vorgesehen sein, daß für eine Schwingungsdämpfung alle vorhandenen piezoelektrischen Elemente im Ruhezustand oder in einer Phase geringer Schwingungsanregung als Sensoren konfiguriert sind. Auftretende Störungen werden dann von allen piezokeramischen Elementen aufgenommen und durch eine entsprechende Regelung können dann alle oder auch nur bestimmte piezokeramische Elemente anschließend als Aktuatoren aktiviert werden. Diese Ausgestaltung hat den Vorteil, daß es nicht erforderlich ist, bestimmte piezoelektrische Elemente als Sensoren oder als Aktuatoren ausweisen zu müssen. Es ist lediglich eine entsprechende Regel- bzw. Steuereinrichtung vorzusehen.

In einer weiteren vorteilhaften Ausgestaltung der Erfindung kann z.B. die zu deformierende Fläche vollflächig oder nahezu vollflächig mit einer piezoelektrischen Schicht oder Folie versehen sein. In diese Schicht werden dann, z.B. über Laser, Strukturen eingeformt. Auf diese Weise können die verschiedensten Muster geschaffen werden. Versieht man dabei die Strukturen unterschiedlichster Art jeweils mit Anschlüssen, so lassen sich durch eine entsprechende Aktivierung die verschiedensten Deformationszonen bzw. Bereiche und Deforamtionsstärken an beliebigen Stellen erreichen. Dabei lassen sich dann auch die einzelnen Strukturen völlig separat ansteuern, womit völlig verschiedenartige Deformationen und Krafteinwirkungen in Abhängigkeit von den gewünschten Korrekturen bzw. Ergebnissen erreichbar sind.

Weitere vorteilhafte Ausgestaltungen und Weiterbildungen der Erfindung ergeben sich aus den Unteransprüchen und aus den nachfolgend anhand der Zeichnung prinzipmäßig beschriebenen Ausführungsbeispielen.

Es zeigt:
- Figur 1: in perspektivischer Prinzipdarstellung einen Spiegel mit einer zu deformierenden Rückseite,
- Figur 2: eine Draufsicht auf eine zu deformierende Fläche,
- Figur 3: eine Draufsicht auf eine zu deformierende Fläche in einer anderen Ausführungsform,
- Figur 4: eine vergrößerte Darstellung von zwei piezoelektrischen Elementen gemäß Figur 3, einmal als Aktuator und einmal als Sensor,
- Figur 5: eine Draufsicht auf eine zu deformierende Fläche mit ringförmigen piezoelektrischen Elementen,
- Figur 6: eine Seitenansicht der Figur 5,
- Figur 7: eine Draufsicht auf eine zu deformierende Fläche mit radial verlaufenden piezoelektrischen Elementen,
- Figur 8: eine Seitenansicht der Figur 7,
- Figur 9: einen Spiegel, bei dem eine durch Gewichtskraft auftretende Deformation kompensiert wird, und
- Figur 10: eine Linse, bei der eine durch Gewichtskraft auftretende Deformation kompensiert wird.

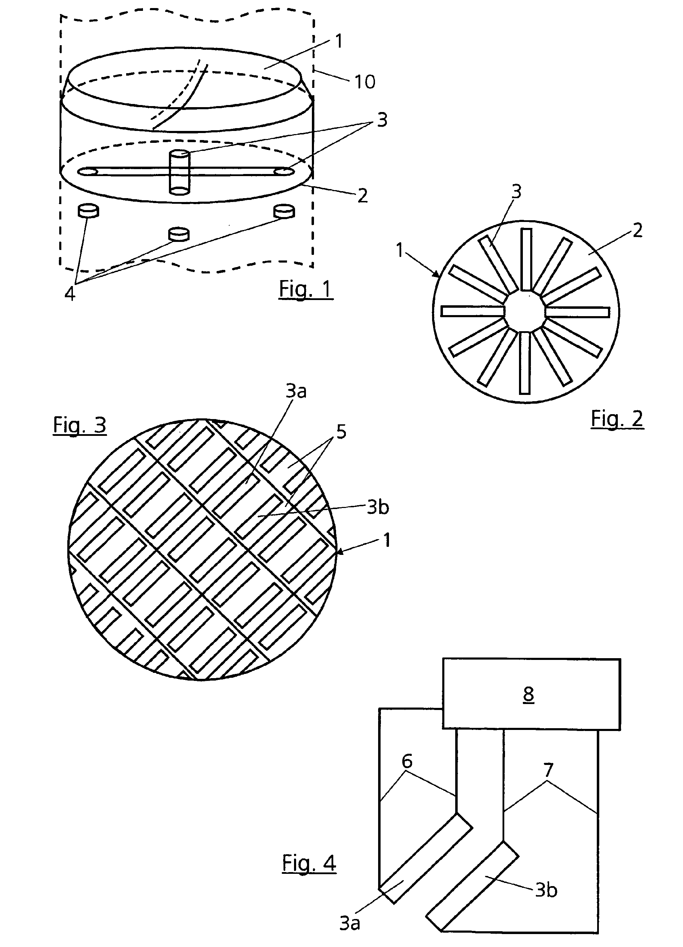

Gemäß Figur 1 ist ein Spiegel 1 auf seiner Rückseite 2 als zu deformierende Fläche mit piezoelektrischen Elementen 3 versehen. Gemäß Darstellung sind zwei piezoelektrische Elemente 3 vorgesehen, welche eine Kreuzform bilden.

Zur Detektion des Deformationszustandes sind mit geringem Abstand zu der Rückseite 2 kapazitive Abstandssensoren 4 vorgesehen. Die piezoelektrischen Elemente 3 sind in das Spiegelmaterial integrierte oder auf die Rückseite 2 aufgeklebte piezoelektrische Keramikfolien (PZT-Folien), welche z.B. eine Dicke von wenigen µm aufweisen können. Bei Ansteuerung der PZT-Folien erfahren diese entsprechend des piezoelektrischen Effektes eine Dehnung, welche über die Verbindung zum Spiegelsubstrat Kräfte auf den Spiegel aufprägt, was zu dessen Deformation führt. Zur Erzeugung beliebiger Deformationszustände in beliebiger Winkelorientierung sind vielfältige "Muster" denkbar. In der Regel wird man die piezoelektrischen Elemente für niedrige Welligkeiten vorsehen, wobei die jedoch selbstverständlich nicht einschränkend ist.

Aus der Vielzahl möglicher Muster sind beispielsweise in Figur 2 piezoelektrische Elemente in Streifenform vorgesehen, welche in radialer Richtung entsprechend über den Umfang verteilt an der zu deformierenden Fläche verlaufen und auf diese Weise eine Art Speichenform ergeben.

Die Figur 3 zeigt ein sehr abstrahiertes Muster mit einer Vielzahl von Feldern 5, in welchen jeweils ein piezoelektrisches Element 3a als Sensor und 3b als Aktuator angeordnet ist.

Aus der vergrößerten Darstellung in der Figur 4 ist ersichtlich, daß die piezoelektrischen Elemente als Sensoren 3a mit Steuerleitungen 6 und die piezoelektrischen Elemente 3b als Aktuatoren mit Steuerleitungen 7 versehen sind. Die Steuerleitungen 6 und 7 stellen die Verbindung zu einer Rechner/Auswerteeinheit 8 her und bilden einen adaptonischen Regelkreis. In diesem Fall sind selbstverständlich sämtliche Sensoren 3a und Aktuatoren 3b entsprechend über die Auswerte- und Regeleinheit 8 miteinander verknüpft. Das in der Figur 3 dargestellte Muster mit den Sensoren 3a und den Aktuatoren 3b kann durch Aufkleben einer entsprechenden Vielzahl von einzelnen piezoelektrischen Elementen gebildet werden. Alternativ dazu kann man die gesamte zu deformierende Fläche, in diesem Fall die Rückseite 2 des Spiegels 1, mit einer Folie beschichten und anschließend entsprechende Strukturen beliebiger Form, Kontur und Ausgestaltung einbringen, z.B. durch Ätzvorgänge oder durch die Bearbeitung mit einem Laser, wodurch eine entsprechende Vielzahl einzelner Strukturen entsteht, die unabhängig voneinander sind, und die jeweils mit Steuerleitungen 6 und 7 versehen werden. Durch eine derartige Ausgestaltungen läßt sich praktisch jede gewünschte Deformation erreichen. Derartige Deformationen können z.B. im Nanometerbereich liegen.

Wenn statt einem Spiegel als optisches Element eine Linse für eine Deformation vorgesehen ist, dann müssen die piezoelektrischen Elemente 3 selbstverständlich in Bereichen angeordnet werden, die optisch nicht aktiv sind. Darüber hinaus steht in diesem Fall auch die Umfangsfläche der Linse für Deformationszwecke zur Verfügung.

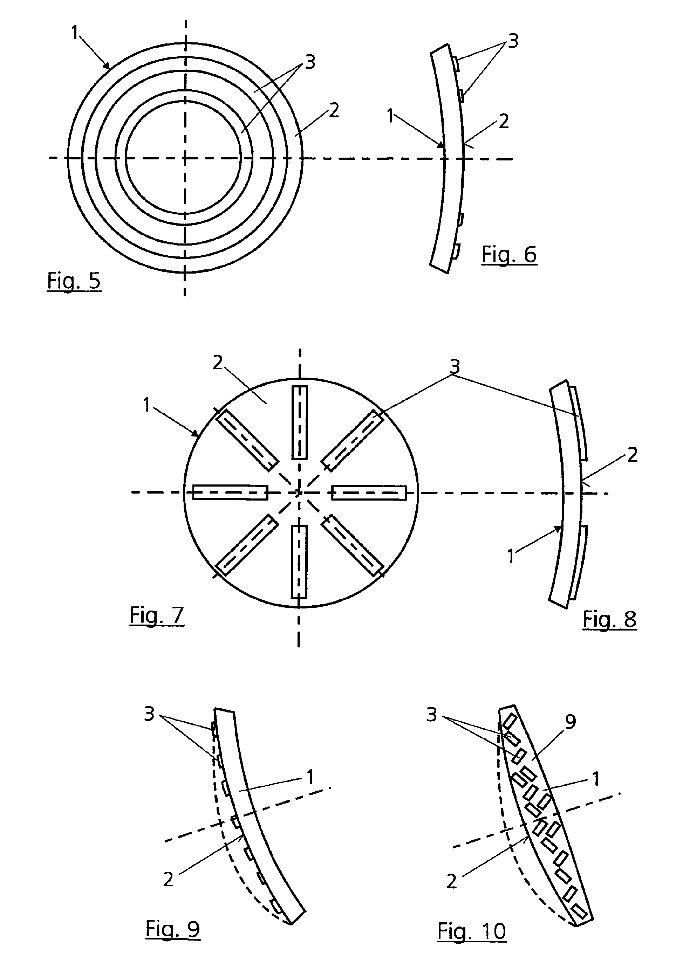

In den Figuren 5 bis 8 sind zwei Ausführungsbeispiele zur gezielten Deformation eines Spiegels 1 vorgesehen, durch den der Fokus bzw. die Spiegelbrennweite variiert werden kann. Der Zweck ist es, einen Spiegel für optische Systeme zu erhalten, insbesondere für einen Wellenbereich von Lambda ≥ 157 nm, der eine im Betrieb zu variierende Spiegelbrennweite erlaubt, um so zum einen eine Art Zoomsystem zu erhalten und zum anderen auch systeminterne Längenänderungen, wie z.B. Temperaturdrift, Alterungserscheinungen, Materialermüdungen, Druckänderungen und dergleichen, durch ein Nachführen der Brennweite korrigieren zu können. Hierzu werden z.B. piezoelektrische Elemente 3, die in Ringform auf die Unterseite 2 des Spiegels aufgebracht werden (siehe Figuren 5 und 6) oder die radial verlaufen und eine Speichenform ergeben (Figuren 7 und 8), verwendet. Durch Ansteuerung dieser Elemente kann gezielt die Oberfläche des Spiegels mit dem gewünschten Effekt deformiert werden. Auch hier wird die Deformation über einen adaptronischen Regelkreis mit Sensoren, z.B. ebenfalls in Form von piezoelektrischen Elementen, erfolgen.

Sowohl bei dem Ausführungsbeispiel nach den Figuren 1 bis 3 als auch nach den Figuren 5 bis 8 können die piezoelektrischen Elemente 3 auch zur aktiven Deformationsverstellung verwendet werden, um z.B. die Abbildungsgenauigkeit einer Projektionsbelichtungsanlage mit einem Projektionsobjektiv 10 (in Figur 1 nur gestrichelt angedeutet), in welches das zu deformierende optische Element eingebaut ist, im Sinne einer Verbesserung der Gesamtabbildungsgenauigkeit zu erhöhen bzw. um an anderer Stelle auftretende Fehler zu kompensieren.

In den Figuren 9 und 10 sind zwei Beispiele, nämlich für einen Spiegel 1 (Figur 9) und für eine Linse 9 (Figur 10) dargestellt, wobei jeweils schräg zur Vertikalen liegende Gewichtskrafteffekte kompensiert werden sollen. Im allgemeinen liegt die optische Achse bei Halbleiter-Objektiven vertikal bzw. parallel zur Schwerkraft. In dieser Lage ergeben sich durch den Einfluß der Schwerkraft vorwiegend rotationssymmetrische Deformationen der optischen Elemente und somit auch rotationssymmetrische Bildfehler. Es ist jedoch auch vorgesehen, in Lithographie-Systemen die optischen Achsen der Elemente horizontal oder in einem bestimmten Winkel zur Schwerkraftrichtung zu legen. Auf diese Weise ergeben sich nicht rotationssymmetrische Deformationen der optischen Elemente.

Durch piezoelektrische Elemente 3, die in Form von PZT-Folien aufgebracht werden, läßt sich durch deren Aktivierung jeweils eine Kraft und/oder ein Moment auf das entsprechende optische Element aufbringen. Dabei werden die Größen der aufzubringenden Kräfte und Momente so gewählt, daß deren Wirkung der Wirkung der Schwerkraft entgegengesetzt gerichtet ist und damit der Gewichtskrafteffekt beseitigt oder zumindest wesentlich reduziert wird.

Wie aus der Figur 9 ersichtlich ist, werden hierzu die piezoelektrischen Elemente 3 auf die Rückseite 2 des Spiegels 1 aufgeklebt und heben bei deren geregelten Aktivierung die Deformation durch die Schwerkraft, welche in der Figur 9 stark übertrieben gestrichelt dargestellt ist, auf. Zusätzlich oder anstelle einer Anordnung auf der Rückseite 2 des Spiegels 1 können piezoelektrische Elemente auch im Randbereich oder an der Umfangswand des Spiegels 1 angeordnet sein.

Auf ähnliche Weise wird die auf der Gewichtskraft reduzierenden Deformation der Linse 9 gemäß Figur 10 durch piezoelektrische Elemente 3, die über den Umfang der Linse verteilt angeordnet sind, reduziert. Auch hier ist gestrichelt und stark übertrieben der Verlauf einer durch die Gewichtskraft deformierten Linse 9 dargestellt.

## Patentansprüche

1. Projektionsbelichtungsanlage für die Halbleiterlithographie mit optischen Elementen (1,9), wobei piezoelektrische Elemente (3) in Form von dünnen Platten, Folien oder Schichten auf zu deformierende Flächen (2) der optischen Elemente (1,9) aufgebracht oder in diese integriert sind, wobei in Verbindung mit einem adaptronischen Regelkreis (6,7,8) mit Sensoren (3a) und durch eine geregelte Aktivierung der piezoelektrischen Elemente (3) als Aktuatoren (3b) über dabei erzeugte Kräfte und/oder Momente eine gezielte Deformation eines oder mehrerer der optischen Elemente (1,9) erfolgt und wobei der Regelkreis (6,7,8) in der Weise konfiguriert ist, dass er mindestens ein piezoelektrisches Element (3) sowohl als Sensor (3a) auslesen als auch als Aktuator (3b) ansteuern kann.

2. Projektionsbelichtungsanlage nach Anspruch 1, **dadurch gekennzeichnet, dass** als Sensoren piezoelektrische Elemente (3a) vorgesehen sind, die über den Regelkreis (6,7,8) mit den piezoelektrischen Elementen als Aktuatoren (3b) verbunden sind.

3. Projektionsbelichtungsanlage nach Anspruch 1 oder 2, **dadurch gekennzeichnet, dass** alle piezoelektrischen Elemente (3) im Ruhezustand oder in einer Phase geringer Schwingungsanregung als Sensoren (3a) konfiguriert sind, und dass bei auftretenden Störungen alle oder ein Teil der piezoelektrischen Elemente (3) als Aktuatoren (3b) aktiviert werden.

4. Projektionsbelichtungsanlage nach Anspruch 1, **dadurch gekennzeichnet, dass** als Sensoren kapazitive Abstandssensoren (4) vorgesehen sind, die über den Regelkreis (6,7,8) mit den piezoelektrischen Elementen als Aktuatoren (3b) verbunden sind.

5. Projektionsbelichtungsanlage nach einem der Ansprüche 1 bis 4, **dadurch gekennzeichnet, dass** die piezoelektrischen Elemente (3) durch Keramikfolien gebildet sind.

6. Projektionsbelichtungsanlage nach einem der Ansprüche 1 bis 5, **dadurch gekennzeichnet, dass** die piezoelektrischen Elemente (3) strukturiert auf den zu deformierenden Flächen (2) der optischen Elemente (1,9) aufgebracht sind.

7. Projektionsbelichtungsanlage nach einem der Ansprüche 1 bis 6, **dadurch gekennzeichnet, dass** bei einem Spiegel (1) als optischem Element Sensoren (3a) und piezoelektrische Elemente als Aktuatoren (3b) auf der Rückseite (2) oder im Randbereich des Spiegels angeordnet sind.

8. Projektionsbelichtungsanlage nach Anspruch 6, **dadurch gekennzeichnet, dass** die piezoelektrischen Elemente (3) zur Fokusänderung bzw. Brennweitenänderung in radialer Richtung verlaufend auf der Rückseite (2) in Speichenform angeordnet sind.

9. Projektionsbelichtungsanlage nach Anspruch 7, **dadurch gekennzeichnet, dass** zur Fokusänderung bzw. Brennweitenänderung die piezoelektrischen Elemente (3) in Form von Umfangsringen mit unterschiedlichen Durchmessern auf der Rückseite (2) angeordnet sind.

10. Projektionsbelichtungsanlage nach einem der Ansprüche 1 bis 9, **dadurch gekennzeichnet, dass** die zu deformierenden Flächen (2) wenigstens annähernd vollflächig mit piezoelektrischen Elementen (3) versehen, insbesondere beschichtet, sind, wobei zur gezielten Deformation die piezoelektrischen Elemente (3) strukturiert sind.

11. Projektionsbelichtungsanlage nach einem der Ansprüche 1 bis 10, **dadurch gekennzeichnet, dass** die piezoelektrischen Elemente (3) zur Beseitigung von Deformationen aufgrund von Gewichtskräften den Gewichtskräften entgegengerichtet auf den deformierten Flächen (2) orientiert sind.

12. Projektionsbelichtungsanlage nach Anspruch 11, **dadurch gekennzeichnet, dass** die die Gewichtskräfte kompensierenden piezoelektrischen Elemente (3) bei einem Spiegel (1) als optischem Element auf dessen Rückseite (2) angeordnet sind.

13. Projektionsbelichtungsanlage nach Anspruch 11, **dadurch gekennzeichnet, dass** bei einer Linse (9) als optisches Element die der Gewichtskraft entgegengesetzt gerichtet wirkenden piezoelektrischen Elemente (3) über den Umfang der Linse (9) verteilt angeordnet sind und/oder in optisch unwirksamen Bereichen liegen.

14. Verfahren zur gezielten Deformation eines optischen Elements (1,9) in einer Projektionsbelichtungsanlage, wobei in einem ersten Verfahrensschritt eine Spannung, die an einem an dem optischen Element (1,9) angebrachten und aus einer dünnen Platte, Folie oder Schicht aufgebauten piezoelektrischen Element (3) anliegt, mittels einer Auswerteeinheit (8) detektiert wird und in einem zweiten Verfahrensschritt die anliegende Spannung mittels der Auswerteeinheit (8) ausgewertet wird und in einem dritten Verfahrensschritt zur gezielten Deformation des optischen Elements dem piezoelektrischen Element eine elektrische Spannung gemäß der Auswertung des vorangegangenen Verfahrensschritts auferlegt wird.

## Claims

1. Projection exposure apparatus for semiconductor lithography having optical elements (1, 9), wherein piezoelectric elements (3) in the form of thin plates, films or layers are applied onto those surfaces (2) of the optical elements (1, 9) which are to be deformed, or are integrated therein, wherein a controlled deformation of one or more of the optical elements (1, 9) is carried out in conjunction with an adaptronic control loop (6, 7, 8) having sensors (3a) and by regulated activation of the piezoelectric elements (3) as actuators (3b), by means of forces and/or moments thereby generated, and wherein the control loop (6, 7, 8) is configured in such a way that it can both read out at least one piezoelectric element (3) as a sensor (3a) and drive it as an actuator (3b).

2. Projection exposure apparatus according to Claim 1, **characterised in that** piezoelectric elements (3a), which are connected via the control loop (6, 7, 8) to the piezoelectric elements as actuators (3b), are provided as sensors.

3. Projection exposure apparatus according to Claim 1 or
2, **characterised in that** all the piezoelectric elements (3) are configured as sensors (3a) in the idle state or in a phase of low oscillatory excitation, and **in that** all or some of the piezoelectric elements (3) are activated as actuators (3b) when perturbations occur.

4. Projection exposure apparatus according to Claim 1, **characterised in that** capacitive distance sensors (4), which are connected via the control loop (6, 7, 8) to the piezoelectric elements as actuators (3b), are provided as sensors.

5. Projection exposure apparatus according to one of Claims 1 to 4, **characterised in that** the piezoelectric elements (3) are formed by ceramic films.

6. Projection exposure apparatus according to one of Claims 1 to 5, **characterised in that** the piezoelectric elements (3) are applied in a structured way onto those surfaces (2) of the optical elements (1, 9) which are to be deformed.

7. Projection exposure apparatus according to one of Claims 1 to 6, **characterised in that** in the case of a mirror (1) as an optical element, sensors (3a) and piezoelectric elements as actuators (3b) are arranged on the rear side (2) or in the edge region of the mirror.

8. Projection exposure apparatus according to Claim 6, **characterised in that** the piezoelectric elements (3) are arranged in the form of spokes extending in the radial direction on the rear side (2) for focus modification or focal length modification.

9. Projection exposure apparatus according to Claim 7, **characterised in that** the piezoelectric elements (3) are arranged in the form of circumferential rings with different diameters on the rear side (2) for focus modification or focal length modification.

10. Projection exposure apparatus according to one of Claims 1 to 9, **characterised in that** the surfaces (2) to be deformed are provided, in particular coated, at least approximately surface-wide with piezoelectric elements (3), the piezoelectric elements (3) being structured for controlled deformation.

11. Projection exposure apparatus according to one of Claims 1 to 10, **characterised in that** in order to avoid deformations due to weight forces, the piezoelectric elements (3) are oriented in an opposite direction to the weight forces on the deformed surfaces (2).

12. Projection exposure apparatus according to Claim 11, **characterised in that** the piezoelectric elements (3) compensating for the weight forces, in the case of a mirror (1) as an optical element, are arranged on its rear side (2).

13. Projection exposure apparatus according to Claim 11, **characterised in that** in the case of a lens (9) as an optical element, the piezo elements (3) acting in a direction opposite to the weight force are arranged distributed over the circumference of the lens (9) and/or lie in optically inactive regions.

14. Method for the controlled deformation of an optical element (1, 9) in a projection exposure apparatus, wherein a stress which is exerted on a piezoelectric element (3), fitted on the optical element (1, 9) and made from a thin plate, film or layer, is detected by means of an evaluation unit (8) in a first method step and the exerted stress is evaluated by means of the evaluation unit (8) in a second method step, and in a third method step an electrical voltage is applied to the piezoelectric element according to the evaluation in the previous method step for controlled deformation of the optical element.

## Revendications

1. Installation d'illumination par projection pour la lithographie des semi-conducteurs comportant des éléments optiques (1, 9), dans laquelle des éléments piézo-électriques (3) présentant la forme de plaquettes minces, de pellicules ou de couches, sont fixés à des surfaces à déformer (2) des éléments optiques (1, 9) ou sont intégrés dans ces surfaces, dans laquelle, en combinaison avec un circuit de régulation adaptronique (6, 7, 8) comportant des capteurs (3a), et sous l'effet d'une activation régulée des éléments piézo-électriques (3) jouant le rôle d'actionneurs (3b), on obtient sous l'action de forces et/ou de couples produits à ce moment, une déformation voulue d'un ou de plusieurs des éléments optiques (1, 9), et dans laquelle le circuit de régulation (6, 7, 8) est configuré de telle manière qu'il puisse aussi bien appeler au moins un élément piézo-électrique (3) utilisé comme capteur (3a) que piloter cet élément utilisé comme actionneur (3b).

2. Installation d'illumination par projection selon la revendication 1, **caractérisée en ce que**, comme capteurs, sont prévus des éléments piézo-électriques (3a) qui sont reliés aux éléments piézo-électriques utilisés comme actionneurs (3b) par l'intermédiaire du circuit de régulation (6, 7, 8).

3. Installation d'illumination par projection selon la revendication 1 ou 2, **caractérisée en ce que**, à l'état de repos ou dans une phase de faible excitation en vibration, tous les éléments piézo-électriques (3) sont configurés en capteurs (3a), et **en ce que**, en présence de perturbations, tous les éléments piézo-électriques (3) ou une partie de ces éléments sont activés en actionneurs (3b).

4. Installation d'illumination par projection selon la revendication 1, **caractérisée en ce qu'**il est prévu comme capteurs des capteurs de distance capacitifs (4) qui sont reliés par l'intermédiaire du circuit de réglage (6, 7, 8) aux éléments piézo-électriques utilisés comme actionneurs (3b).

5. Installation d'illumination par projection selon l'une des revendications 1 à 4, **caractérisée en ce que** les éléments piézo-électriques (3) sont constitués par des pellicules de céramique.

6. Installation d'illumination par projection selon l'une des revendications 1 à 5, **caractérisée en ce que** les éléments piézo-électriques (3) sont fixés de façon structurée sur les surfaces à déformer (2) des éléments optiques (1, 9).

7. Installation d'illumination par projection selon l'une des revendications 1 à 6, **caractérisée en ce que**, dans le cas d'un miroir (1) constituant l'élément optique (3a), des capteurs et des éléments piézo-électriques utilisés comme actionneurs (3b) sont disposés sur la face arrière (2) ou dans la région marginale du miroir.

8. Installation d'illumination par projection selon la revendication 6, **caractérisée en ce que** les éléments piézo-électriques (3) destinés à la modification du foyer ou à la modification de la distance focale sont disposés sur la face arrière (2), à la façon de rayons, en s'étendant dans une direction radiale.

9. Installation d'illumination par projection selon la revendication 7, **caractérisée en ce que**, pour la modification du foyer ou la modification de la distance focale, les éléments piézo-électriques (3) sont disposés sur la face arrière (2) sous la forme d'anneaux circonférentiels de différents diamètres.

10. Installation d'illumination par projection selon l'une des revendications 1 à 9, **caractérisée en ce que** les surfaces à déformer (2) sont pourvues, en particulier revêtues, d'éléments piézo-électriques (3) au moins à peu près sur toute la surface, les éléments piézo-électriques (3) étant structurés pour obtenir la déformation voulue.

11. Installation d'illumination par projection selon l'une des revendications 1 à 10, **caractérisée en ce que**, pour éviter des déformations qui résulteraient de forces de gravité, les éléments piézo-électriques (3) sont orientés sur les surfaces déformées (2) en sens inverse des forces de gravité

12. Installation d'illumination par projection selon la revendication 11, **caractérisée en ce que**, dans le cas où c'est un miroir (1) qui constitue l'élément optique, les éléments piézo-électriques (3) qui compensent les forces de gravité sont disposés sur la face arrière (2) de l'élément.

13. Installation d'illumination par projection selon la revendication 11, **caractérisée en ce que**, dans le cas où c'est une lentille (9) qui constitue l'élément optique, les éléments piézo-électriques (3) qui agissent en sens inverse de la force de gravité sont répartis sur le pourtour de la lentille (9) et/ou se trouvent dans des régions optiquement inactives.

14. Procédé pour la déformation voulue d'un élément optique (1, 9) dans une installation d'illumination par projection, dans lequel, dans une première étape du procédé, une tension, qui est présente sur un élément piézo-électrique (3) constitué par une plaquette mince, une pellicule ou une couche et fixé à l'élément optique (1, 9), est détectée au moyen d'une unité d'analyse (8), dans une deuxième étape du procédé, la tension présente est analysée au moyen de l'unité d'analyse (8) et, dans une troisième étape du procédé, pour réaliser la déformation voulue de l'élément optique, une tension électrique est appliquée à l'élément piézo-électrique en fonction de l'analyse de l'étape précédente du procédé.
